# EUROPEAN PATENT APPLICATION

(11) **EP 2 903 396 A1**
(43) Date of publication of application: **05.08.2015**
(21) Application number: 15157969.5
(22) Date of filing: 21.01.2013
(51) Int. Cl.: H05B 33/08, G01R 31/40, G01R 31/44, G01R 31/02, G01R 31/26, H01L 25/075, H01L 25/16, H01L 27/15, H05B 37/02, H05B 41/39, H01L 33/62

(54) **Secondary side phase-cut dimming angle detection**

(30) Priority: 20.01.2012 US 201261588838 P
(62) Divisional of application: 13705289.0
(71) Applicant: OSRAM SYLVANIA INC., Danvers, MA 01923 (US)
(72) Inventor: Siessegger, Bernhard, Danvers, MA Massachusetts 01923 (US); Pollischansky, Thomas, 81371 München (DE); Nordhausen, Markus, 81539 München (DE)
(74) Representative: Viering, Jentschura & Partner Patent- und Rechtsanwälte

(57) **Abstract**

Phase angle detection techniques for phase-cut dimming lighting circuitry are disclosed. A phase-cut lighting driver circuit may include galvanic isolation circuitry having a primary and secondary side. The phase angle information of a phase-cut signal may be detected on the secondary side of the driver circuitry, and a microcontroller can create a dimming signal that adjusts the driver output power according to the phase angle information. In some embodiments, the phase angle detection techniques may be utilized to control the output of lighting driver circuitry, such as a phase-cut dimming LED driver.

## Description

### RELATED APPLICATION

This application claims priority to U.S. Provisional Application No. 61/588,838, filed January 20, 2012, which is herein incorporated by reference in its entirety.

### FIELD OF THE DISCLOSURE

The present application relates to lighting circuitry, and more specifically to phase angle detection for phase-cut dimming circuitry.

### BACKGROUND

Light emitting diode (LED)-based lighting design, as well as other lighting driver circuitry design, involves a number of non-trivial challenges, and dimmable light fixtures have faced particular complications.

### BRIEF DESCRIPTION OF THE DRAWINGS

Figure 1 shows a high level block diagram of a dimming LED driver, according to one embodiment of the present invention.
Figure 2 shows a more detailed block diagram of a dimming LED driver, according to one embodiment of the present invention.
Figure 3a shows a circuit design of a dimming LED driver utilizing a flyback converter, configured according to one embodiment of the present invention.
Figure 3b shows circuit design of a phase-cut dimming system including a communication interface, according to one embodiment of the present invention.
Figure 4 shows a circuit design of a dimming LED driver utilizing an alternative sensing network, configured according to one embodiment of the present invention.
Figure 5a shows a circuit design of a dimming LED driver with an external comparator, configured according to one embodiment of the present invention.
Figure 5b is a timing diagram corresponding to different points along the circuit of Figure 5a.
Figure 6 shows a circuit design of a dimming LED driver utilizing a push-pull converter, configured according to one embodiment of the present invention.
Figure 7 shows a circuit design of an LED driver with simplified detection circuitry, according to one embodiment of the present invention.
Figure 8 shows a circuit design of an LED driver with simplified detection circuitry and multiple LED strings controlled by the same dimming signal, according to one embodiment of the present invention.
Figure 9 is a flowchart illustrating a method of measuring and utilizing phase angle information, according to one embodiment of the present invention.

### DETAILED DESCRIPTION

Techniques are disclosed for detecting phase angle information in lighting circuitry based on leading or trailing edge phase-cut dimming. Lighting driver circuitry may include, for example, LED drivers, electronic ballasts for fluorescent or High Intensity Discharge (HID) lighting systems, incandescent lighting circuitry, or other suitable lighting circuitry. In order to achieve low harmonic distortion for the input current and at the same time a low ripple on the output current, an LED driver may be implemented with Power Factor Correction (PFC). In some embodiments, galvanic isolation of the output of the driver from its input is employed. Dimming circuitry may detect the phase angle information and create a dimming signal to control the brightness level of the LEDs. In some embodiments, the dimming circuitry may be on the secondary side of a galvanically isolated LED driver circuit. The dimming signal may be based on the conduction phase angle of the phase-cut dimmer connected to the line input of the LED driver. The dimming signal may also include a brightness value that is calculated based on the phase angle of the phase-cut signal. In some cases, information about the phase angle on the primary side of the circuit is detected by a processor on the secondary side of the circuit. The resultant fixtures have a broad range of applications, such as in office lighting, commercial lighting, signage lighting, display backlighting applications, or any lighting application where dimming is desired. Numerous configurations and variations will be apparent in light of this disclosure.

### General Overview

As previously explained, lighting driver circuitry design involves a number of non-trivial challenges. For instance, consider dimmable light fixtures configured to achieve phase angle detection for phase-cut lighting driver circuitry. In general, phase angle information on the primary side of the transformer must be accessible on the secondary side in order to adapt the output power according to the phase angle of the line input. Typically, this phase angle information may be detected on the primary side and communicated to the secondary side of the transformer using an optocoupler. In order to control the brightness level of a lighting system, a Digital Addressable Lighting Interface (DALI) controller or a 0-10V dimming controller may be implemented to provide the desired dimming value to the output of the circuit. Other dimming controllers may be implemented also. Optocouplers are expensive components and often unreliable, therefore the optocoupler as well as the dimming control circuitry add complexity and cost.

Thus, and in accordance with an embodiment of the present invention, a lighting circuitry topology is provided which does not require an optocoupler or other primary side phase detection circuitry; rather, phase angle information is detected on the secondary side. In some embodiments, PFC and galvanic isolation circuitry are present. Galvanic isolation may be provided, for example, with a transformer. Numerous applications for such architecture will be apparent in light of this disclosure. For instance, the ability to measure the phase angle information on the secondary side of the transformer and map that phase angle information to a useful dimming value allows a phase-cut dimmer to be utilized with an LED driver circuit (or other light driver such as ballast circuitry) without the need for an optocoupler and also without the use of an independent DALI or 0-10V dimming controller, thus reducing circuit complexity, size, and cost. In addition, the disclosed techniques allow near-unity power factor and low harmonic distortion in the line input current while providing a low ripple on the output current, in some embodiments.

### Circuit Architecture

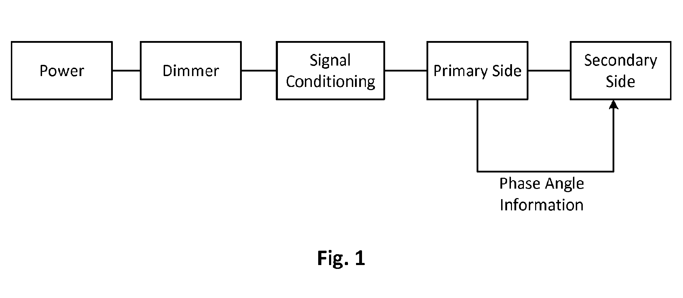

Figure 1 shows a high level block diagram of a phase-cut dimming LED driver, according to one embodiment of the present invention. The power source provides power to a dimmer, which is connected to the signal conditioning element. According to one embodiment, the signal conditioning element comprises a voltage rectifier, and a line phase-cut dimmer may be connected to the rectifier input to provide the initial phase-cut signal. The signal conditioning element may also comprise a high-frequency generator that is fed by the output of the voltage rectifier. The conditioned signal may then be sent to the primary side of the galvanic isolation circuitry in the LED driver. The secondary side of the galvanic isolation circuitry detects the phase angle information and adjusts the output power to an LED string based on the detected phase angle. The phase angle information may be detected on the secondary side of a transformer without using an optocoupler or other primary side detection circuitry.

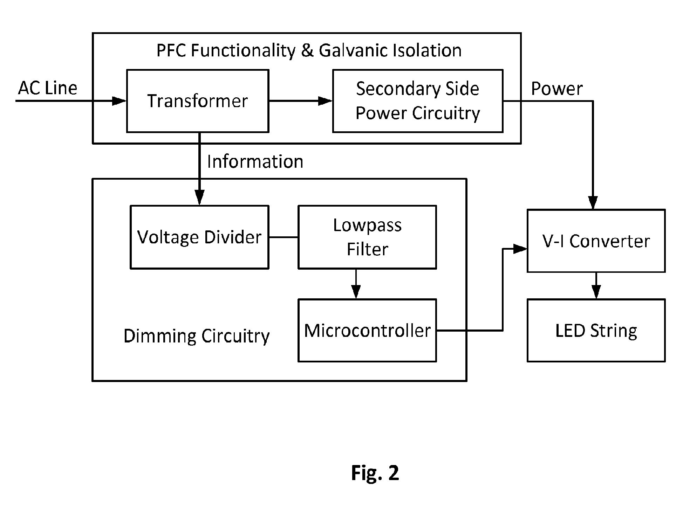

Figure 2 shows an expanded block diagram of an LED driver implementing secondary side phase angle detection, according to one embodiment of the present invention. The transformer provides galvanic isolation for the driver circuitry and may be connected to or part of a PFC circuitry. Power factor correction (PFC) circuitry may be composed of a control circuitry on the primary side (not shown), the transformer and secondary side power circuitry. The PFC circuitry is part of one or more power converter(s) which include the transformer and the secondary side power circuitry. The secondary side power circuitry may include rectifier stage and energy storage, e.g. a bulk or intermediate-bus capacitor. Besides being connected to the secondary side power circuitry, the secondary side of the transformer is also connected to dimming circuitry, which in this particular embodiment includes a voltage divider, a low-pass filter, and a microcontroller for detecting phase angle information. In one specific embodiment, a signal is received by the transformer from a voltage rectifier. In one such embodiment, a flyback converter may be implemented to provide galvanic isolation as well as PFC functionality. In another embodiment, a push-pull converter may provide galvanic isolation and PFC functionality. Other suitable converters may be implemented to provide these functions, as will be appreciated in light of this disclosure. The low-pass filter can be used to eliminate high-frequency components on the AC signal or any unwanted switching spikes that may result from the dimmer switch or signal conditioning elements. The microcontroller detects the phase angle information by analyzing the pulsewidth of the signal at the output of the low-pass filter, and creates a dimming signal that may be sent to the V-I converter. In one particular embodiment, the V-I converter is a buck converter, while in another embodiment a linear regulator may be used. However, other suitable converters will be apparent in light of this disclosure. The converter is generally called a V-I converter because it is fed by a voltage source and its output appears to the LEDs as a current source. Compared to existing single stage topologies (which are commonly used in "LED lamps" for retrofitting screw-based incandescent lamps, e. g. utilizing a single stage flyback converter without an additional V-I converter), the described two stage approach (two power stages, e.g. a flyback converter followed by buck converter as used in one embodiment of the present invention) allows reduced light modulation of the LEDs, in particular reduced light modulation of twice the line frequency.

In one example embodiment, the dimming circuitry, as well as the V-I converter, may be implemented on a single chip that may be operatively coupled with the secondary side of the transformer. The PFC circuitry may also be integrated on a chip. As will be appreciated in light of this disclosure, the degree of integration with respect to the various elements of the LED driver circuitry will vary from one embodiment to the next. Other embodiments may be implemented with discrete components populated, for example, on a printed or wired circuit board. Further note that the microcontroller may already exist in a given design, and can be further programmed or otherwise configured to carry out the techniques provided herein, including phase angle detection and dimming signal generation. Numerous other embodiments and configurations of varying degrees of integration configured for secondary side detection of phase angle information and dimming signal generation will be apparent in light of this disclosure.

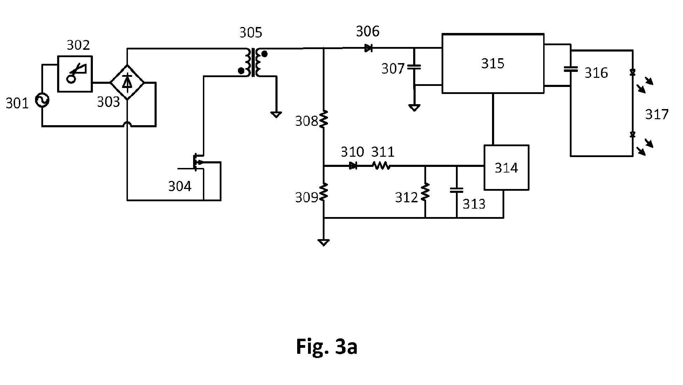

Figure 3a shows a circuit design of an LED driver according to one embodiment of the present invention. The circuit includes an AC voltage source 301, a dimmer switch 302, a voltage rectifier 303, a flyback converter with PFC functionality, a dimming circuit, a V-I converter 315, and a string of LEDs 317. In this particular embodiment, the flyback converter includes transistor 304 connected to the primary side of transformer 305, and diode 306 and capacitor 307 and a flyback control circuitry (not shown) driving the transistor 304, all three of them on the secondary side of transformer 305. The phase angle may be detected on the secondary side of transformer 305 by the dimming circuit. In this particular embodiment, the dimming circuit includes a voltage divider with resistors 308 and 309, a rectifying diode 310, a low-pass filter comprising resistor 311 and capacitor 313, a discharging resistor 312 connected in parallel with capacitor 313, and a microcontroller 314. This dimming circuit provides a dimming signal based on the phase angle of the phase-cut dimmer 302 that is detected by the microcontroller.

In operation, if dimmer 302 is in a conducting state and transistor 304 is switching, then an AC signal is present at the secondary side of transformer 305. When dimmer 302 is not conducting, in principle there is no AC signal present, even though depending on the actual implementation one may find some noise and potentially some switching spikes from transistor 304. The voltage divider comprising resistors 308 and 309 works along with the diode 310 to scale down the amplitude of the AC signal and to rectify the signal to make it appropriate for input into microcontroller 314. Low-pass filter comprising resistor 311 and capacitor 313 can filter any high frequency components of the AC signal that may be present, including the switching frequency of transistor 304. In one particular embodiment, the time constant of the filter can be chosen to be on the order of 100 microseconds, which is about 10 times larger than the average switching period of transistor 304 when 303 is switching; however numerous other suitable time constants can be used as will be apparent in light of this disclosure. The low-pass filter may also serve to eliminate switching spikes created by transistor 304 during the non-conducting phase of dimmer 302, which were mentioned above. Resistor 312 serves to continuously discharge capacitor 313 to prevent it from charging up to the maximum voltage of the AC signal, thus assuring that the voltage on capacitor 313 decreases while dimmer 302 is not conducting.

In one particular embodiment, a microcontroller 314 is programmed or otherwise configured to analyze the signal on capacitor 313 and deduce the phase angle by analyzing the pulsewidth of this signal. Depending on the phase angle of the input signal, a corresponding dimming signal may be created on the output of microcontroller 314 and sent to converter 315. The output of the microcontroller 314 may be, for example, a digital output signal (standard IO pin, output of pulse width modulation (PWM) module), or an analog output (DAC output or PWM output with low-pass filtering), and can be used for setting the reference signal for the converter 315 and therefore establishing a current amplitude (analog dimming) or average current (PWM dimming) that may be presented to the LED string 317. Whether analog dimming or PWM dimming is used depends on the application, design constraints, and other factors considered for the design of an LED driver. Often PWM dimming utilizing a PWM frequency above 200 Hz is preferred over analog dimming, as the PWM dimming allows a higher dimming range compared with analog dimming, and due to the high PWM frequency of more than 200 Hz it is ensured that a strobing-free (sometimes also referred to as flicker-free) light from the LEDs is generated. The LED string may be connected in parallel to capacitor 316. Given that the converter 315 is fed by a voltage source and its output appears to the LEDs 317 as a current source, it may generally be referred to as a V-I converter. In one particular embodiment, the V-I converter 315 is a buck converter. In another embodiment, a linear regulator may be used to implement the converter; however, other suitable converters will be apparent in the art in light of this disclosure.

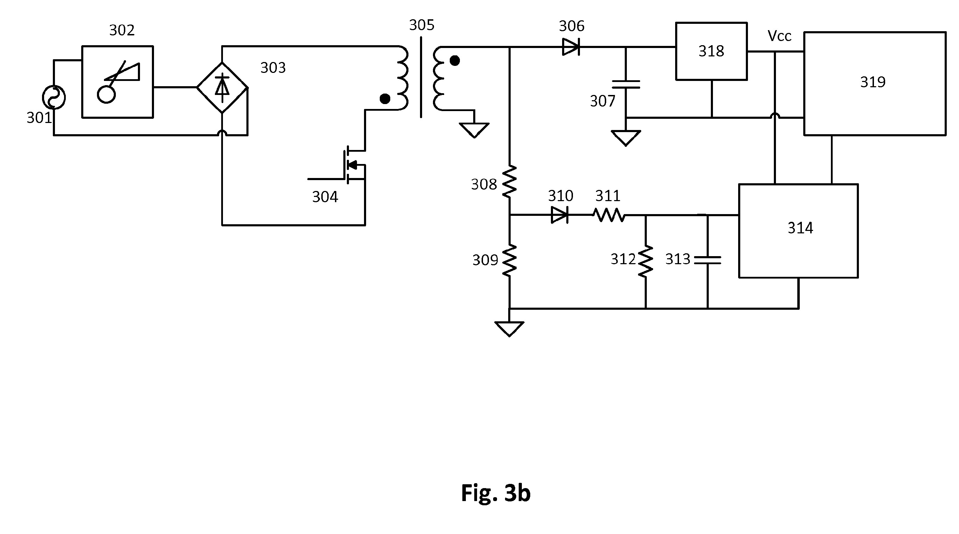

Figure 3b shows a circuit design of a phase-cut dimming system including a communication interface, according to one embodiment of the present invention. Similar to the circuit described in reference to Figure 3a, this example circuit includes an AC voltage source 301, a dimmer switch 302, a voltage rectifier 303, a flyback converter with PFC functionality, a dimming circuit, a linear regulator 318, and a string of LEDs 317. This particular example circuit, however, includes a communications interface 319 instead of the LED string shown in Figure 3a. In this example embodiment, diode 306, capacitor 307, and linear regulator 318 provide voltage Vcc to the microcontroller and the communication interface (which are galvanically isolated from the mains). Such an embodiment may be used in other lighting devices besides LED drivers or LED power supplies; i.e. non-power processing (only information processing) lighting devices.

In one example embodiment, the communication interface may include a DALI interface, so that the phase-cut dimming system serves as a phase-cut to DALI converter, which may also be called a "bridge" or "translator" device. In such an example, "converter" does not necessarily mean a power converter, but rather an information converter - converting one way of coding information into another way of coding the information. This particular example circuitry provides the phase angle information or the DALI lighting brightness value to other devices connected to the DALI communication interface. Other converters like phase cut to DMX or phase-cut to wireless are also feasible. In one such example, the microcontroller senses the phase-cut angle and communicates this information via a communication interface 319 to other devices. In some embodiments, this type of communication may be DALI, DMX, wireless communication like ZigBee-based wireless communication, power line communication, etc. In one example embodiment, the microcontroller 314 may communicate a dimmer signal or phase-cut angle to the communication interface 319. The value might be either an analog value or digital communication between microcontroller 314 and the communication interface 319. In some embodiments, the communication interface may include its own microcontroller. In some embodiments, the communication interface may be connected to a DALI bus. In this particular example, the microcontroller 314 and communication interface 319 are described as distinct, however, in some cases one microcontroller may be able to detect the phase angle, convert it to a dimming signal, and communicate with other lighting devices, thus combining the microcontroller 314 and communication interface 319 into a single microcontroller or chip set.

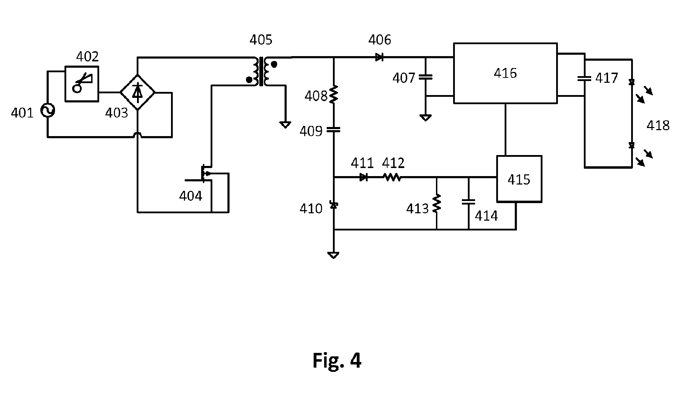

Figure 4 shows another circuit design of an LED driver according to one embodiment of the present invention. This particular embodiment includes an AC voltage source 401, a dimmer switch 402, a voltage rectifier 403, a transistor 404, a transformer 405, diode 406, and capacitor 407. Compared to the circuit shown in Figure 3a, this embodiment replaces the resistor voltage divider of 308 and 309 with resistor 408, capacitor 409, and Zener diode 410. The AC component of the voltage on the secondary side of transformer 404 may be coupled to the dimming circuit using capacitor 409. Zener diode 410 can clamp the amplitude of the signal seen by the microcontroller so that the microcontroller input voltage range will not be exceeded. Resistor 408 limits the peak current through diodes 411 and 410 and is an optional component. Low-pass filter comprising resistor 412 and capacitor 414 can filter any high frequency components of the AC signal that may be present, including the switching frequency of transistor 404. The low-pass filter may also serve to eliminate switching spikes created by transistor 404 during the non-conducting phase of dimmer 402. Resistor 413 serves to continuously discharge capacitor 414 to prevent it from charging up to the maximum voltage of the AC signal, thus assuring that the voltage on capacitor 414 decreases while dimmer 402 is not conducting.

Microcontroller 415 is programmed or otherwise configured to analyze the signal on capacitor 414 and detect the phase angle by analyzing the pulsewidth of this signal. Depending on the phase angle of the input signal, a corresponding dimming signal may be created on the output of the microcontroller and sent to converter 416. The output of the microcontroller may be, for example, a digital output signal (standard I/O pin, output of pulse-width modulation (PWM) module, or an analog output (digital-to-analog converter (DAC) output or PWM output with low-pass filtering), which sets the reference signal for the converter 416 and therefore establishes a current amplitude (analog dimming) or average current (PWM dimming) that may be presented to the LED string 418. The LED string may be connected in parallel to capacitor 417. As can be seen, the converter 416 is fed by a voltage source and its output appears to the LEDs as a current source, thus it may generally be called a V-I converter. In one particular embodiment, the V-I converter is a buck converter. In another embodiment a linear regulator may be used, however, other suitable converters will be apparent in the art in light of this disclosure.

For determining the phase angle information, the time constant of the low-pass filter comprising resistor 412 and capacitor 414 may be chosen to be on the order of a few line cycles, significantly larger than the 100 microseconds previously discussed with reference to the example embodiment of Figure 3a. In this particular embodiment, the amplitude of the voltage on capacitor 414, and hence the amplitude of the input signal of microcontroller 415 may be used to determine the phase angle. The lower the voltage, the greater the dimming (and the less light will be generated by the LEDs). The analog signal present on the input may then be digitized by an analog to digital converter (ADC) inside microcontroller 415.

Depending on the implementation, there may still be some ripple, with twice the line frequency, on the voltage of capacitor 414. This voltage ripple can be reduced, for example, by increasing the capacitance of the capacitor 414, but this may limit dynamic performance. To avoid having the LED current modulated with twice the line voltage, the A/D conversion of this voltage may be synchronized with the mains so that the voltage is always sampled at the same time during each half-cycle of the line. In addition, digital filters may be implemented in firmware within the microcontroller 415 and may be utilized to filter out unwanted frequency components (e.g. frequency components with twice the line frequency).

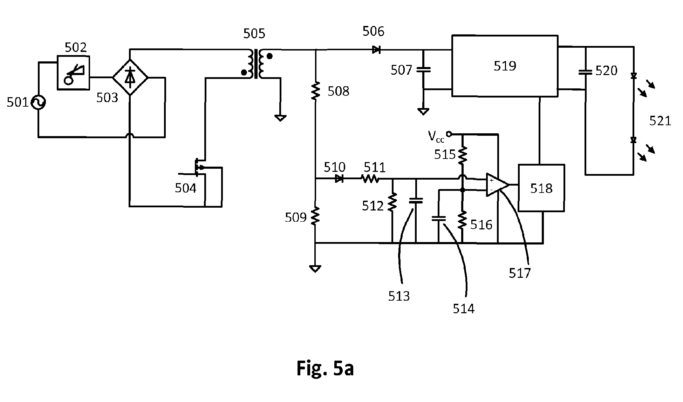

Figure 5a shows another circuit design of an LED driver according to one embodiment of the present invention. This particular embodiment includes AC source 501, dimmer switch 502, voltage rectifier 503, and a flyback converter including transistor 504, a flyback control circuitry (not shown) driving the transistor 504, transformer 505, diode 506, and capacitor 507. The flyback converter can provide galvanic isolation as well as PFC functionality. This flyback-PFC implementation can enable a cost-effective input stage which is dimmable on leading and trailing edge phase-cut dimmers. In this particular example, the dimming circuit includes a voltage divider with resistors 508 and 509, a rectifying diode 510, a low-pass filter comprising resistor 511 and capacitor 513, a discharging resistor 512 connected in parallel with capacitor 513, and a microcontroller 518. The voltage divider comprising resistors 508 and 509 can work along with the diode 510 to scale down the amplitude of the AC signal to make it appropriate for input into microcontroller 518. Low-pass filter comprising resistor 511 and capacitor 513 can filter any high frequency components of the AC signal that may be present, including the switching frequency of transistor 504. The low-pass filter may also serve to eliminate switching spikes created by transistor 504 during the non-conducting phase of dimmer 502. Resistor 512 serves to continuously discharge capacitor 513 to prevent it from charging up to the maximum voltage of the AC signal, thus assuring that the voltage on capacitor 513 decreases while dimmer 502 is not conducting. Although microcontroller 518 may have an on-chip analog comparator, an external comparator 517 may also be used as shown. Resistors 515 and 516 and capacitor 514 can create a reference of, for example, half the supply voltage V_{cc} to comparator 517. The supply voltage V_{cc} is created inside the LED driver, but for sake of conciseness and readability, is not shown in Figure 5a. In this example embodiment, comparator 517 creates the digital signal that is fed to the microcontroller 518. The output of microcontroller 518 may be sent to the buck converter 519 (or other suitable V-I converter) which at its output is connected to capacitor 520 and LED string 521.

In one specific example implementation of the circuit shown in Figure 5a, the component values listed in Table 1 are used. The microcontroller 518 can be implemented, for instance, with an AVR ATtiny10 6-pin microcontroller by Atmel Corporation, although any number of suitable microcontrollers can be used, as will be appreciated in light of this disclosure. To the output converter 519, the microcontroller 518 emulates a DALI control board. Whenever the dimming angle changes, a serial command is sent to the control input of the output converter 519 (which can be implemented, for example, with a PIC16F microcontroller by Microchip Technology Inc). This serial command is compatible with commands of Optotronic DALI controllers. This implementation with an intervening peripheral interface controller (PIC) was chosen for expediency, and alternatively a PWM signal from microcontroller 518 for directly controlling the output converter 519 can be implemented. The comparator chosen in this particular embodiment is the TS951ILT from STMicroelectronics. In other embodiments, a comparator within the microcontroller 518 could be used, as will be appreciated. In such case, firmware within the microcontroller can be programmed or otherwise configured to detect the direction of the slopes (to identify the rising edge pair or the falling edge pair so that timing measurements can be made between the two like slopes). These example component values are provided for illustrative purposes only, and the claimed invention is not intended to be limited to any particular set of components or values, and numerous other values and configurations will be apparent in light of this disclosure.

**Table 1: Example components and values**

| **Reference** | **Component / Value** |
|---|---|
| 513 | 10nF |
| 514 | 100nF |
| 510 | L4150 |
| 508 | 62k |
| 509 | 10k |
| 511 | 10k |
| 512 | 10k |
| 515 | 100k |
| 516 | 100k |
| 517 | TS951ILT (ST) |
| 518 | ATtiny10 (ATMEL) |

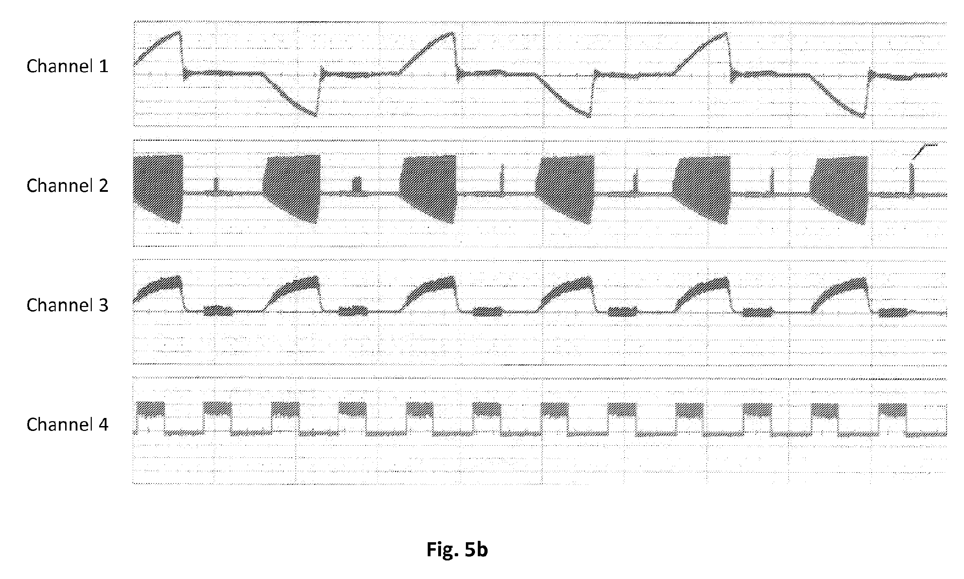

Figure 5b is a timing diagram showing measured waveforms at various points in the circuit of Figure 5a, implemented according to one embodiment of the present invention. Channel 1 shows the input voltage following the phase-cut dimmer 502, prior to voltage rectifier 503. Channel 2 shows the voltage on the secondary side of transformer 505, prior to diode 506 and resistor 508. When dimmer 502 is on (conducting), this waveform represents an AC signal similar to the phase-cut line voltage, with high frequency fluctuations due to the flyback switching. However, as seen, there are additional short periods during the non-conducting time of dimmer 502 where noise spikes are present, in this example case. Channel 3 shows the output signal of the detection circuit (the voltage across capacitor 513). The signal is matched at this point to the input levels used by the microcontroller 518. Most of the on-time switching frequency and the off-time noise are filtered out at this point. Channel 4 shows the current for the LED string 521. The LED current in this particular embodiment is pulsewidth modulated with 240 Hz and 40% duty cycle, corresponding to approximately a 40% dim level of the light on the LED string 521.

Note that the applicability of the techniques provided herein is independent of whether the LED driver provides constant current, constant voltage, or constant power as its output to the LEDs. For any of these cases, the principles outlined for detecting phase angle information, performing signal processing, and creating a dimming signal as described herein can be used. As will be further appreciated, the techniques may be used for other isolated topologies, as well as for non-isolated PFC topologies, as outlined below.

### Other Isolated PFC Topologies

The PFC flyback converter is one isolating PFC topology that may be used for LED drivers, however, one could use other isolated single-switch PFC topologies, such as the isolated single-ended primary-inductor converter (SEPIC), Ćuk converter, or ZETA converters. For higher power levels, the voltage fed half-bridge converter or the current fed push-pull converter can also be used in this context. Note that the current fed push-pull converter is not a common or otherwise typical PFC topology for LED drivers, as the switch voltages tend to be high, and hence this topology is mainly suited for low line voltages (e.g. 120V_{ac}). As will be appreciated in light of this disclosure, the claimed invention is not intended to be limited to an implementation with any particular converter, microcontroller, or V-I converter configuration but can be used with numerous configurations in numerous applications.

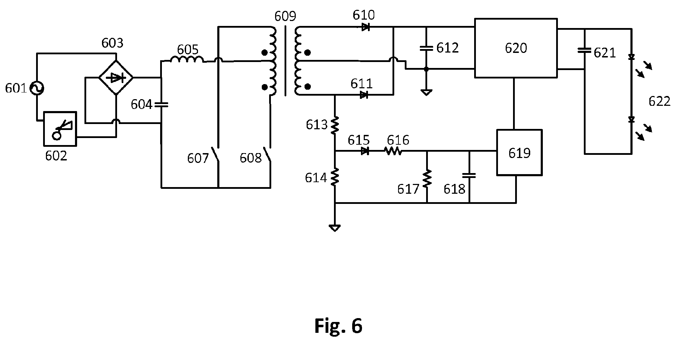

Figure 6 shows a circuit design of an LED driver according to one embodiment of the present invention which is fed by an AC voltage source 601 through the dimmer 602. A current fed push-pull converter is used as part of the LED driver to provide galvanic isolation. In this particular embodiment, power to the push-pull converter is connected to capacitor 640 which is charged through AC voltage source 601, the dimmer 602 and rectifier 603. The push-pull converter includes an inductor 605 connected to capacitor 604, a transformer 609, push-pull switches 607 and 608, diodes 610 and 611, and capacitor 612. The transformer 609 has a center-tabbed primary as well as a center-tabbed secondary side. The switches 607 and 608 on the primary side of transformer may alternately power their respective ends of the transformer. Diodes 610 and 611 are each connected to opposite ends of the secondary side of the transformer and are connected in series with capacitor 612. The phase angle detection circuit in this particular embodiment includes a voltage divider comprising resistors 613 and 614, rectifying diode 615, low-pass filter comprising resistor 616 and capacitor 618, discharging resistor 617, and microcontroller 619. The voltage divider comprising resistors 613 and 614 works along with diode 615 to scale down the amplitude of the AC signal to make it appropriate for input into microcontroller 619. Low-pass filter comprising resistor 616 and capacitor 618 can filter out undesired high frequency components of the AC signal that may be present. Resistor 617 serves to continuously discharge capacitor 618 to prevent it from charging up to the maximum voltage of the AC signal, thus assuring that the voltage on capacitor 618 decreases while dimmer 602 is not conducting.

Microcontroller 619 is programmed or otherwise configured to analyze the signal on capacitor 618 and deduce phase angle information by analyzing the pulsewidth of this signal. The output of microcontroller 619 may be fed to converter 620, whose output drives the LED string 622. Thus, depending on the phase angle of the initial phase-cut signal, a corresponding dimming signal may be created on the output of the microcontroller 619 and sent to converter 620. As previously explained, the output of the microcontroller 619 may be a digital output signal (standard IO pin, output of PWM module, etc.), or an analog output (DAC output or PWM output with low-pass filtering), which sets the reference signal for the converter and therefore establishes a current amplitude (analog dimming) or average current

(PWM dimming) that may be presented to the LED string 622. The LED string may be connected in parallel to capacitor 621.

### Simplified Detection Circuitry

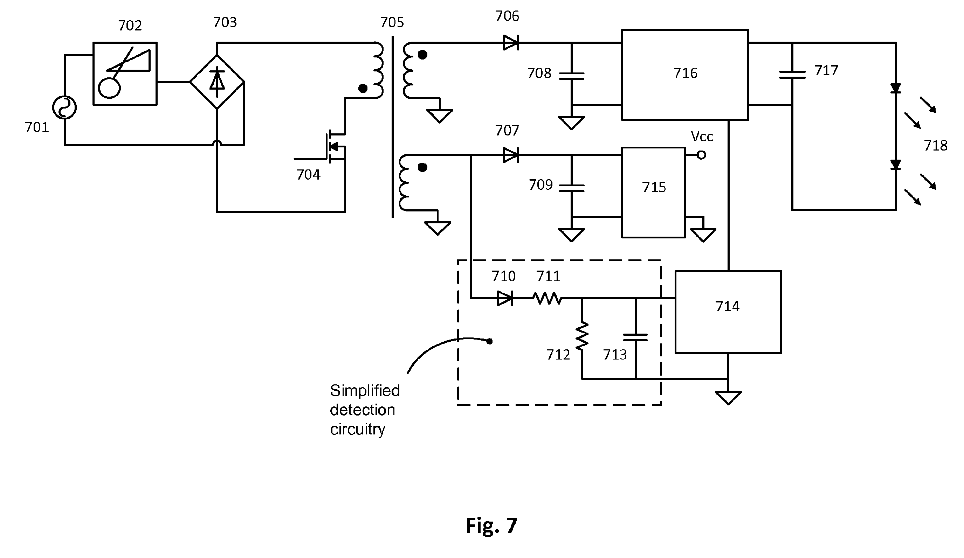

Figure 7 shows a circuit design of an LED driver with simplified detection circuitry, according to one embodiment of the present invention. This particular embodiment includes an AC voltage source 701, a dimmer switch 702, a voltage rectifier 703, and a flyback converter with PFC functionality. In this particular embodiment, the flyback converter provides two output voltages and includes a transistor 704, a transformer 705, diodes 706 and 707, and capacitors 708 and 709. In this example, the transformer 705 includes two secondary windings, the first connected to V-I converter 716 via diode 706, and the second connected to auxiliary supply 715 via diode 707. The simplified detection circuitry is connected to the secondary side of transformer 705 and includes diode 710, resistors 711-712, and capacitor 713. This particular example illustrates a more simplified detection circuit design compared to the circuitry described in reference to Figure 6 because only two, instead of four, resistors are used while the functionality remains unchanged. In this particular embodiment, resistor 712 is part of the low-pass filter and at the same time drains capacitor 713 over time. The simplified detection circuitry is connected to microcontroller 714, which provides a dimming signal to the V-I converter 716. The output of converter 716 drives the LED string 718, and the LED string may be connected in parallel to capacitor 717.

In this particular example embodiment, the detection of the phase angle is done on a different secondary winding than the one providing power to the V-I converter 716. This might be advantageous, as the voltage on the winding that is providing the power might be higher than on the winding that is used for the auxiliary power supply 715 (which may provide e.g. Vcc=5V for the microcontroller and other control circuitry), hence the voltage divider (resistors 711-712) doesn't need to be dimensioned for high voltage which may lead to lower losses.

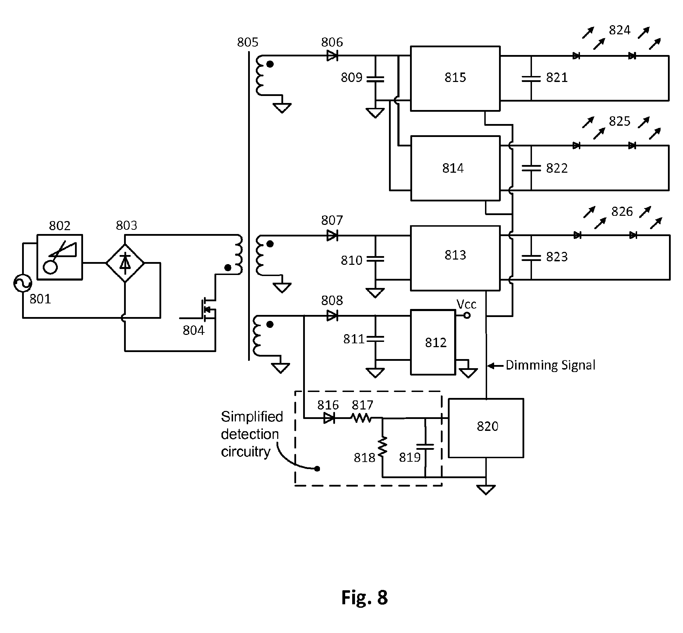

Figure 8 shows a circuit design of an LED driver with simplified detection circuitry and multiple LED strings controlled by the same dimming signal, according to one embodiment of the present invention. This particular example circuit includes an AC voltage source 801, a dimmer switch 802, a voltage rectifier 803, and a flyback converter with PFC functionality. In this particular embodiment, the flyback converter provides three output voltages on capacitors 809-811 and includes a transistor 804, a transformer 805, diodes 806-808, and capacitors 809-811. In this example, the transformer 705 includes three secondary windings, the first connected to V-I converters 814 and 815 via diode 806, the second connected to V-I converter 813 via diode 807, and the third connected to auxiliary supply 812 via diode 808. The simplified detection circuitry is connected to the secondary side of transformer 805 and includes diode 816, resistors 817-818, and capacitor 819. The simplified detection circuitry is connected to microcontroller 820, which provides a dimming signal or brightness value to each of the V-I converters 813-815. The dimming signal may include a DALI brightness value, a 0-10V brightness value, or any other suitable brightness value. The output of converter 815 drives the LED string 824, and the LED string may be connected in parallel to capacitor 821. The output of converter 814 drives LED string 825 and the LED string may be connected in parallel to capacitor 822. The output of converter 813 drives LED string 826 and the LED string may be connected in parallel to capacitor 823.

### Non-isolated PFC Topologies

As previously indicated, the techniques provided herein need not be limited to topologies with isolating PFC circuitry, as will be appreciated. The same principles for detecting phase angle information may be implemented, for example, with topologies having a non-isolating PFC stage where sensing of the PFC switching signal may take place at a node before the intermediate bus capacitor. For instance, in a driver with a Boost-PFC, one may connect the phase angle detection circuit (such as resistor 308, 408, 508, or 613 of Figures 3a-b, 4, 5a, or 6, respectively) to the gate drive pin of a PFC control IC. One example such IC is the L6562, available from STMicroelectronics. Depending on the requirements of the specific embodiment, the output stage may provide galvanic isolation. Assuming the control of the output stage (whether isolated or non-isolated) is located on the primary side, a microcontroller calculating the dimming signal may be utilized for controlling the output stage as well. For an isolated PWM-dimmable output stage, one example embodiment could use an additional optocoupler for communicating the dimming signal from the primary side to the secondary side. In other embodiments having an analog current dimming output stage (e.g., a forward-converter or a resonant half-bridge converter), or in the case of a non-isolated driver, the phase angle detection techniques provided herein can be used.

### Methodology

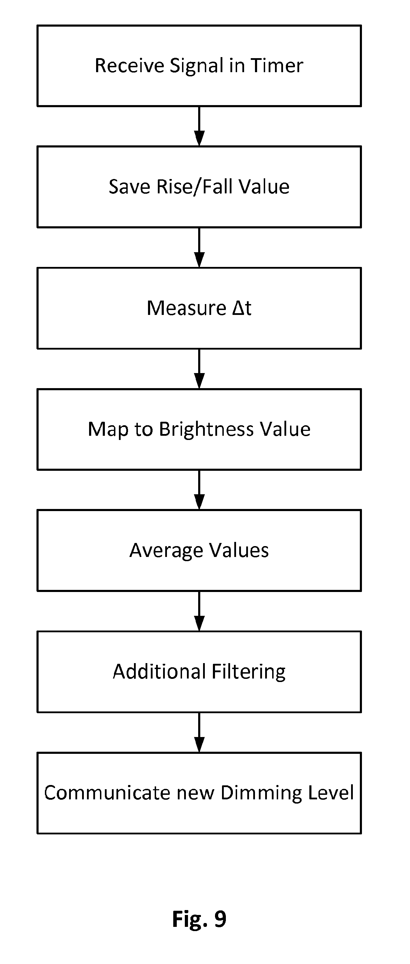

Figure 9 is a flow diagram illustrating a method for measuring phase angle information of a phase-cut line voltage and controlling the output of an LED driver, according to one embodiment of the present invention. This method may be carried out, for example, at least in part by a phase measurement module programmed or otherwise configured into the microcontroller (e.g., firmware), as discussed with reference to 314, 415, 518, 619, 714, and 820 of Figures 3a-b, 4, 5a, 6, 7, and 8 respectively. In one particular example embodiment, a timer inside an ATtiny10 microcontroller manufactured by ATMEL (or any other suitable microcontroller) can receive the phase-cut signal. Whenever the voltage on the corresponding pin of the microcontroller changes, either falling or rising edge, firmware within the microcontroller can be programmed or otherwise configured to save the value of the timer. These saved time values are then processed, and the time difference Δt measured by the timer between two consecutive falling and rising edges corresponds to the phase angle. The time measured between two edges of the same kind (e.g., between two falling edges, or two rising edges) corresponds to the line frequency. In cases where the measured frequency is too low, the last timer value captured may be disregarded in order to resynchronize and to avoid generating a wrong dimming level. To this end, the microcontroller firmware can be configured accordingly.

The time difference Δt may then be mapped to a brightness value. In one particular embodiment, the Δt values are mapped to DALI dimming levels to make the phase-cut dimmer compatible with DALI circuitry. In other example embodiments, the phase angle information detected by the microcontroller can be mapped, for example, to correspond with a 0-10V dimming value, or any other suitable brightness value. Continuing with the DALI example, the lower resolution of the DALI level in comparison with the timer represents a first-level filtering. Because the phase angles of the positive and the negative half-wave are often different, an averaging of two or more (preferably an even number of) measured values may be performed. Despite these two levels of filtering, the resulting signal may nonetheless be very noisy, and therefore may require additional filtering of the DALI level. Thus, in some embodiments, Kalman-like filtering, or linear quadratic estimation, may be applied in order to reduce noise. This filtering may be implemented, for example, to create a weighted average of two components: the actual value (new input) and the previously calculated average. The weights for such an averaging operation are computed such that the weight of the actual value is high directly after start-up (powering on of the circuit). With each calculated average, the weighting shifts toward weighing the previous value more than the new value. In other words, the longer the device is powered on, the more it trusts the old values rather than the new value resulting from the last measurement, until a certain weighing end value is reached. The end value and the speed of change as well as the start value can be saved within the controller. The time constant of the Kalman-like filter can be quite short. The calculated weight of the averaging can attain its final value after 6-7 measurements, for example, which in some embodiments may correspond to about 50-70 microseconds after start-up. Thus, the normally weighted average and the one described above differ only during the start-up of the LED driver.

With this example embodiment, the LED driver on start-up has a dimming level close to the desired dimming level. The new dimming level is then communicated. In one specific such case, after filtering, the microcontroller 314 communicates this information via a communication interface 319 to other devices, preferably lighting devices. In another specific such case, after filtering, the ATtiny10 microcontroller sends two bytes of information to the output converter, e.g. a PIC microcontroller manufactured Microchip inside the output converter (for controlling of the output converter such as 315, 416, 519, 620, 716, and 813-815 of Figures 3a-b, 4, 5a, 6, 7, and 8 respectively), thereby the ATtiny10 microcontroller is emulating a DALI control board or DALI interface board. In this specific embodiment, the first byte contains information about the fade time, while the second byte contains the DALI dim level, which can be a value between 0 and 254. The claimed invention is not intended to be limited to the sequence or actions described in this example case, and numerous variations on this methodology will be apparent in light of this disclosure.

Numerous embodiments will be apparent, and features described herein can be combined in any number of configurations. One example embodiment of the present invention provides a phase-cut dimming system. The phase-cut dimming system includes a galvanic isolation circuit having a primary and secondary side, a dimming circuit coupled to the secondary side of the galvanic isolation circuit and configured to detect phase angle information, and an output circuit coupled to the dimming circuit and configured to control output power according to the phase angle information. In some cases, the system further includes power factor correction circuitry that provides galvanic isolation. In some cases, the galvanic isolation circuit includes a push-pull converter. In some cases, the galvanic isolation circuit includes a flyback converter. In some cases, the galvanic isolation circuit includes a half-bridge converter. In some cases, the system further includes a voltage divider within the dimming circuit. In some cases, the system further includes a rectifier within the dimming circuit. In some cases, the system further includes a low-pass filter within the dimming circuit. In some cases, the dimming circuit includes a rectifier which has at least one diode. In some cases, the dimming circuit includes a microcontroller configured to detect phase angle information by analyzing a signal on the secondary side of the driver. In some cases, the system further includes a low-pass filter and a microcontroller for detecting phase angle information by analyzing a signal on a capacitor of the low-pass filter. In one such case, the microcontroller maps the phase angle information to a lighting brightness value. In one such case, the lighting brightness value controls the brightness of at least one lighting element. In one such case, the microcontroller maps the phase angle information to a DALI brightness value. In one such case, the microcontroller maps the phase angle information to a 0-10V brightness value. In one such case, the microcontroller is connected to a communication interface. In some cases, the output circuit further includes a voltage-current (V-I) converter to provide a constant current output. In one such case, the V-I converter is a buck converter. In one such case, the constant current output powers at least one string of LEDs. In some cases, the output circuit includes a communication interface to provide the phase angle information or the lighting brightness value to other devices connected to the communication interface.

Another embodiment of the present invention provides a method for detecting phase angle information. The method includes receiving a phase-cut signal, monitoring the voltage level of the phase-cut signal, measuring the time difference, Δt, between changes in the voltage level of the phase-cut signal, and generating a dimming signal based on the measured time difference. In some cases, receiving a phase-cut signal occurs on the secondary side of a galvanically isolated LED driver circuit. In some cases, the method further includes calculating line frequency by measuring the time between two falling edges or two rising edges. In some cases, the method further includes mapping Δt to a 0-10V brightness value. In some cases, the method further includes mapping Δt to a DALI brightness value. In one such case, the dimming signal includes two bytes, the first byte including information about fade time associated with the dimming signal, the second byte including the DALI dimming level value associated with the dimming signal. In some cases, the method further includes calculating an average-Δt by averaging at least two Δt values. In some cases, the method further includes performing additional linear quadratic estimation filtering on the measured Δt values.

Another embodiment of the present invention provides a system for detecting phase angle information. In this example case, the system includes a microcontroller for receiving a phase-cut signal, a phase angle detection module within the microcontroller for detecting the phase angle of the phase-cut signal, and a brightness module within the microcontroller for computing a lighting brightness value based on the phase angle. In some cases, the phase angle detection module includes a timer for measuring the time difference, Δt, between voltage changes of the phase-cut signal. In one such case, the brightness module maps Δt to a lighting brightness value. In some cases, the system further includes a filtering module for calculating an average-Δt by averaging at least two Δt values.

The foregoing description of the embodiments of the invention has been presented for the purposes of illustration and description. It is not intended to be exhaustive or to limit the invention to the precise form disclosed. Many modifications and variations are possible in light of this disclosure. It is intended that the scope of the invention be limited not by this detailed description, but rather by the claims appended hereto.

Further preferred embodiments will described in the following:
1. A phase-cut dimming system, comprising:
   a galvanic isolation circuit having a primary and secondary side;
   a dimming circuit operatively coupled to the secondary side of the galvanic isolation circuit and configured to detect phase angle information; and
   an output circuit operatively coupled to the dimming circuit and configured to control output power according to the phase angle information.
2. The system of clause 1, further comprising power factor correction circuitry that provides galvanic isolation.
3. The system of clause 1, wherein the galvanic isolation circuit comprises at least one of a push-pull converter, a flyback converter, and/or a half-bridge converter.
4. The system of clause 1, wherein the dimming circuit comprises at least one of a voltage divider, a rectifier, and/or a low-pass filter.
5. The system of clause 1, wherein the dimming circuit comprises a rectifier, and wherein the rectifier comprises at least one diode.
6. The system of clause 1, wherein the dimming circuit comprises a microcontroller configured to detect phase angle information by analyzing a signal on the secondary side of the driver
7. The system of clause 1, wherein the dimming circuit comprises a low-pass filter and a microcontroller configured to detect phase angle information by analyzing a signal on a capacitor of the low-pass filter.
8. The system of clause 7, wherein the microcontroller is further configured to map the phase angle information to a lighting brightness value.
9. The system of clause 7, wherein the lighting brightness value controls the brightness of at least one lighting element.
10. The system of clause 7, wherein the microcontroller is further configured to map the phase angle information to a DALI brightness value.
11. The system of clause 7, wherein the microcontroller is further configured to map the phase angle information to a 0-10V brightness value.
12. The system of clause 7, wherein the microcontroller is connected to a communication interface
13. The system of clause 1, wherein the output circuit comprises a voltage-current (V-I) converter configured to provide a constant current output.
14. The system of clause 13, wherein the V-I converter is a buck converter.
15. The system of clause 13, wherein the constant current output is configured to power at least one string of LEDs.
16. The system of clause 1, wherein the output circuit comprises a communication interface to provide at least one of the phase angle information or the lighting brightness value to other devices connected to the communication interface
17. A method for detecting phase angle information, comprising:
   receiving a phase-cut signal;
   monitoring the voltage level of the phase-cut signal;
   measuring the time difference, Δt, between changes in the voltage level of the phase-cut signal; and
   generating a dimming signal based on the measured time difference.
18. The method of clause 17, wherein receiving a phase-cut signal occurs on the secondary side of a galvanically isolated LED driver circuit.
19. The method of clause 17, further comprising calculating line frequency by measuring the time between two falling edges or two rising edges.
20. The method of clause 17, further comprising mapping Δt to a 0-10V brightness value.
21. The method of clause 17, further comprising mapping Δt to a DALI brightness value.
22. The method of clause 21, wherein the dimming signal comprises two bytes, the first byte including information about fade time associated with the dimming signal, the second byte including the DALI dimming level value associated with the dimming signal.
23. The method of clause 17, further comprising calculating an average-Δt by averaging at least two Δt values.
24. The method of clause 17, further comprising performing additional linear quadratic estimation filtering on the measured Δt values.
25. A system for detecting phase angle information, comprising:
   a microcontroller configured to receive a phase-cut signal;
   a phase angle detection module within the microcontroller configured to detect phase angle of the phase-cut signal; and
   a brightness module within the microcontroller configured to compute a lighting brightness value based on the phase angle.
26. The system of clause 25, wherein the phase angle detection module includes a timer configured to measure the time difference, Δt, between voltage changes of the phase-cut signal, and the brightness module is configured to map Δt to a lighting brightness value.
27. The system of clause 25, further comprising a filtering module configured to calculate an average-Δt by averaging at least two Δt values.

## Claims

1. A system for detecting phase angle information, comprising:
a microcontroller configured to receive a phase-cut signal;
a phase angle detection module within the microcontroller configured to detect phase angle of the phase-cut signal; and
a brightness module within the microcontroller configured to compute a lighting brightness value based on the phase angle.

2. The system of claim 1, wherein the phase angle detection module includes a timer configured to measure the time difference, Δt, between voltage changes of the phase-cut signal, and the brightness module is configured to map Δt to a lighting brightness value.

3. The system of claim 1, further comprising a filtering module configured to calculate an average-Δt by averaging at least two Δt values.
